# FASCICULE DE BREVET EUROPEEN

(11) **EP 0 459 858 B1**
(45) Date de publication et mention de la délivrance du brevet: **21.12.1994**
(21) Numéro de dépôt: 91401263.8
(22) Date de dépôt: 16.05.1991
(51) Int. Cl.: G01N 21/03, G01N 21/47, C30B 35/00

(54) **Dispositif et installation de cristallogénèse pourvus de moyens d'observation**
Vorrichtung und Anlage zur Kristallzüchtung, mit Beobachtungsmitteln ausgestattet
Apparatus and equipment for crystal growth with observation means

(30) Priorité: 31.05.1990 FR 9006792
(43) Date de publication de la demande: 04.12.1991
(73) Titulaire: AEROSPATIALE Société Nationale Industrielle, 75781 Paris Cédex 16 (FR)
(72) Inventeur: Gamelin, Christian, F-33160 Saint Aubin de Medoc (FR)
(74) Mandataire: Bonnetat, Christian

(56) Documents cités:
- EP-A- 0 265 319
- EP-A- 0 289 200
- DD-A- 129 690
- DE-A- 3 904 858
- JOURNAL OF CRYSTAL GROWTH. vol. 73, no. 2, novembre 1985, AMSTERDAM NL pages364 - 368; R.F.KARLICEK ET AL.: "Remote optical monitoring of reactants in a vapor phase epitaxial reactor"

## Description

La présente invention concerne un dispositif et une installation de cristallogénèse pourvus de moyens d'observation de la cristallisation.

On sait que l'une des méthodes d'étude des substances macromoléculaires consiste à former des cristaux desdites substances et à soumettre lesdits cristaux à des examens, notamment spectrographiques. Pour former de tels cristaux, on utilise des méthodes de diffusion, éventuellement à travers une paroi poreuse de diffusion. A cet effet, dans une enceinte, on dispose un creuset rempli d'un mélange liquide d'une substance macromoléculaire à étudier et d'un agent précipitant en concentration insuffisante pour agir, puis on introduit dans ladite enceinte un tel agent précipitant afin de provoquer la cristallisation en diminuant la concentration de substance (phase liquide) ou en l'augmentant (phase vapeur) ou à concentration constante (dialyse).

Par diffusion, la concentration du mélange de l'agent précipitant et de la substance macromoléculaire contenu dans le creuset tend à s'aligner sur celle de l'agent précipitant contenu dans l'enceinte. Par suite, en faisant varier la concentration de ce dernier agent précipitant, on peut agir sur la cristallisation de ladite substance macromoléculaire.

Généralement, le creuset et l'enceinte sont au moins partiellement transparents, de sorte qu'un opérateur peut suivre visuellement le développement de la cristallisation.

Cependant, une telle observation visuelle peut ne pas être assez précise. De plus, elle devient mal aisée sinon impossible, si ledit creuset est de petite taille et/ou si une pluralité d'expériences sont menées simultanément à l'aide d'une installation regroupant une pluralité de creusets, proches les uns des autres.

Par ailleurs, les cristaux obtenus dans les laboratoires terrestres par la mise en oeuvre de ces techniques de diffusion ne sont pas parfaits, tant en qualité qu'en taille, notamment à cause des phénomènes de convexion dus à la pesanteur.

Pour remédier à cet inconvénient, il est avantageux de pouvoir mettre en oeuvre de telles techniques de diffusion à bord de vaisseaux spatiaux, car alors les conditions d'apesanteur éliminent ces phénomènes de convexion.

Il va de soi qu'une telle mise en oeuvre dans l'espace des méthodes de cristallogénèse impose la miniaturisation des creusets et des installations les regroupant. Il est alors nécessaire de prévoir un système automatique d'observation des réactions de cristallogénèse.

A cet effet, par le document EP-A-0 265 319, on connaît déjà un dispositif de cristallogénèse comportant :
- un creuset dans la cavité duquel peut se produire une réaction de cristallisation ;
- des moyens de détection de lumière disposés à l'extérieur de ladite cavité, du côté de la base dudit creuset ; et
- des premiers moyens de transmission de lumière disposés entre la cavité dudit creuset et lesdits moyens de détection de lumière pour prélever dans ladite cavité un premier faisceau lumineux parallèle à une première direction.

L'objet de la présente invention est de perfectionner ce dispositif connu et de permettre l'observation automatique et précise des réactions de cristallisation dans des installations miniaturisées, notamment, mais non exclusivement, à bord de véhicules spatiaux.

A cette fin, selon l'invention, le dispositif du type décrit ci-dessus est caractérisé en ce qu'il comporte :
- des moyens générateurs de lumière disposés à l'extérieur de ladite cavité, du côté de la base dudit creuset ; et
- des seconds moyens de transmission de lumière disposés entre lesdits moyens générateurs de lumière et la cavité dudit creuset pour introduire dans ladite cavité un second faisceau lumineux parallèlement à une seconde direction, qui est transversale par rapport à ladite première direction.

Ainsi, grâce à la présente invention, puisque les moyens générateurs de lumière et les moyens de détection de lumière, associés à chaque creuset, sont disposés sous celui-ci, on peut former des installations de cristallogénèse dans lesquelles une pluralité de creusets sont disposés coplanairement côte à côte, avec un encombrement en longueur et en largeur aussi réduit que possible.

De plus, l'observation de la réaction de cristallisation est précise. En effet, du fait de la disposition desdits premier et second faisceaux, lesdits moyens de détection ne recueillent que la lumière diffusée et/ou diffractée par les cristaux contenus dans la cavité du creuset, c'est-à-dire que, à chaque instant, le signal de sortie desdits moyens de détection est représentatif de la quantité et/ou de la taille desdits cristaux et donc de l'état de la réaction de cristallisation. On remarquera par ailleurs que, grâce à cette disposition, lesdits moyens de détection de lumière ne risquent pas d'être aveuglés par lesdits moyens générateurs de lumière, puisque ledit premier faisceau n'est pas dirigé vers lesdits moyens de détection de lumière.

Avantageusement, dans le dispositif conforme à l'invention, ledit creuset, lesdits moyens de générateurs de lumière, lesdits moyens de détection de lumière, lesdits premiers moyens de transmission de lumière et lesdits seconds moyens de transmission de lumière sont solidaires les uns des autres pour former une unité de cristallogénèse.

De préférence, ladite unité de cristallogénèse comporte un axe géométrique orthogonal à la base dudit creuset et :
- lesdits moyens générateurs de lumière sont excentrés par rapport audit axe ;
- lesdits seconds moyens de transmission comportent au moins un conduit de lumière excentré par rapport audit axe et des moyens de déflexion pour défléchir ledit second faisceau lumineux en direction de la cavité dudit creuset ;
- lesdits moyens de détection de lumière sont centrés sur ledit axe ; et
- lesdits premiers moyens de transmission de lumière sont constitués au moins en partie par la base dudit creuset, qui, à cet effet, est transparente pour ledit premier faisceau lumineux.

Il est alors avantageux :
- que lesdits moyens générateurs de lumière comportent une pluralité de sources lumineuses réparties autour dudit axe ; et
- que lesdits seconds moyens de transmission comportent une pluralité de conduits de lumière, dont chacun d'eux est associé à une source lumineuse.

Lesdits moyens de déflexion peuvent être constitués dans ce cas par un miroir conique, concentrique à l'axe géométrique de ladite unité de cristallogénèse. Ce miroir conique peut être formé par une face métallisée pratiquée dans ledit creuset.

De même, le ou lesdits conduits de lumière peuvent être constitués par des canaux cylindriques à paroi métallisée, formés dans ledit creuset. De tels canaux sont avantageusement parallèles à l'axe de ladite unité de cristallogénèse.

Afin de concentrer, dans lesdits conduits de lumière, la lumière émise par lesdits moyens générateurs de lumière, on prévoit de préférence un système optique de focalisation entre lesdits moyens générateurs de lumière et le ou lesdits conduits de lumière.

De même, un système optique de focalisation est prévu entre la base dudit creuset et lesdits moyens de détection.

Lesdits moyens générateurs de lumière et lesdits moyens de détection de lumière sont avantageusement de type électrique. Par exemple, la ou chaque source desdits moyens générateurs de lumière est constituée par une diode électroluminescente, tandis que lesdits moyens de détection de lumière sont formés par une photodiode, un élément photovoltaïque, un phototransistor ou un détecteur pyroélectrique. Dans ce cas, ledit dispositif de cristallogénèse comporte de plus des moyens de commande pour contrôler lesdits moyens générateurs de lumière et/ou lesdits moyens de détection de lumière et pour délivrer un signal électrique représentatif de l'intensité lumineuse dudit premier faisceau lumineux.

L'invention concerne de plus une installation de cristallogénèse comportant une pluralité de dispositifs, tels que celui spécifié ci-dessus.

Aussi, selon l'invention, une telle installation est remarquable :
- en ce que chaque dispositif comporte :
   . des moyens électriques générateurs de lumière disposés à l'extérieur de ladite cavité, du côté de la base dudit creuset ; et
   . des seconds moyens de transmission de lumière disposés entre lesdits moyens générateurs de lumière et la cavité dudit creuset pour introduire dans ladite cavité un second faisceau lumineux parallèlement à une seconde direction, qui est transversale à ladite première direction ;
- et en ce que sont prévus des moyens de commande pour contrôler lesdits moyens générateurs de lumière et lesdits moyens de détection de lumière et pour délivrer des signaux électriques respectivement représentatifs de l'intensité lumineuse de chacun desdits premiers faisceaux lumineux.

Les figures du dessin annexé feront bien comprendre comment l'invention peut être réalisée. Sur ces figures, des références identiques désignent des éléments semblables.

La figure 1 est une vue, en coupe axiale agrandie, d'un dispositif de cristallogénèse conforme à la présente invention.

La figure 2 est une coupe selon la ligne II-II de la figure 1.

La figure 3 montre le schéma synoptique d'une installation conforme à la présente invention, comportant une pluralité de dispositifs montrés par les figures 1 et 2.

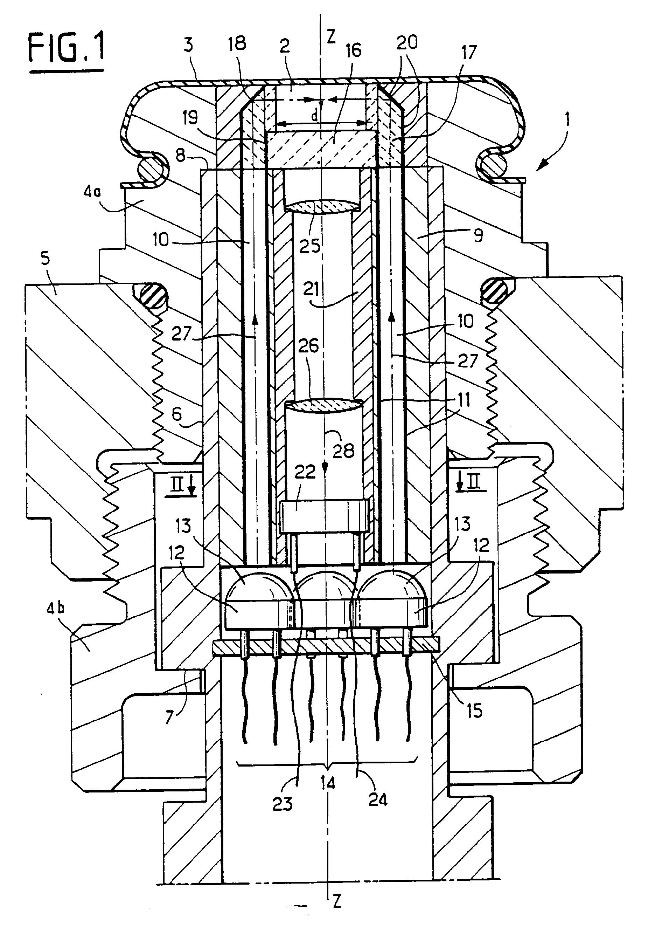

Le dispositif de cristallogénèse 1, conforme à l'invention et montré par la figure 1, comporte un creuset d'axe géométrique Z-Z, présentant une cavité de cristallogénèse 2.

Le processus de cristallogénèse à l'intérieur de la cavité 2 peut être conduit conformément à celui décrit dans le document EP-A-0 265 319. Dans ce cas, le dispositif de cristallogénèse 1 remplace le creuset 4 et le dispositif d'observation 32 décrit dans ce document antérieur. Cependant, le dispositif 1 de la présente invention peut également servir à la mise en oeuvre du processus de cristallogénèse connu décrit ci-dessus en préambule. Sur la présente figure 1, l'enceinte destinée à l'introduction de l'agent précipitant n'est pas représentée. Seule une membrane de diffusion 3, obturant la cavité 2, a été représentée.

Le creuset montré sur la figure 1 comporte deux parties 4a et 4b, permettant de fixer ledit creuset sur un support 5.

Les deux parties de creuset 4a et 4b sont cylindriques et creuses et sont coaxiales à l'axe Z-Z. La cavité 5 est elle-même cylindrique et coaxial à l'axe Z-Z. Son diamètre d peut être de l'ordre de 5 mm.

A l'intérieur des parties de creuset 4a et 4b, est monté un fourreau 6, bloqué entre deux épaulements 7 et 8, respectivement prévus sur lesdites parties de creuset.

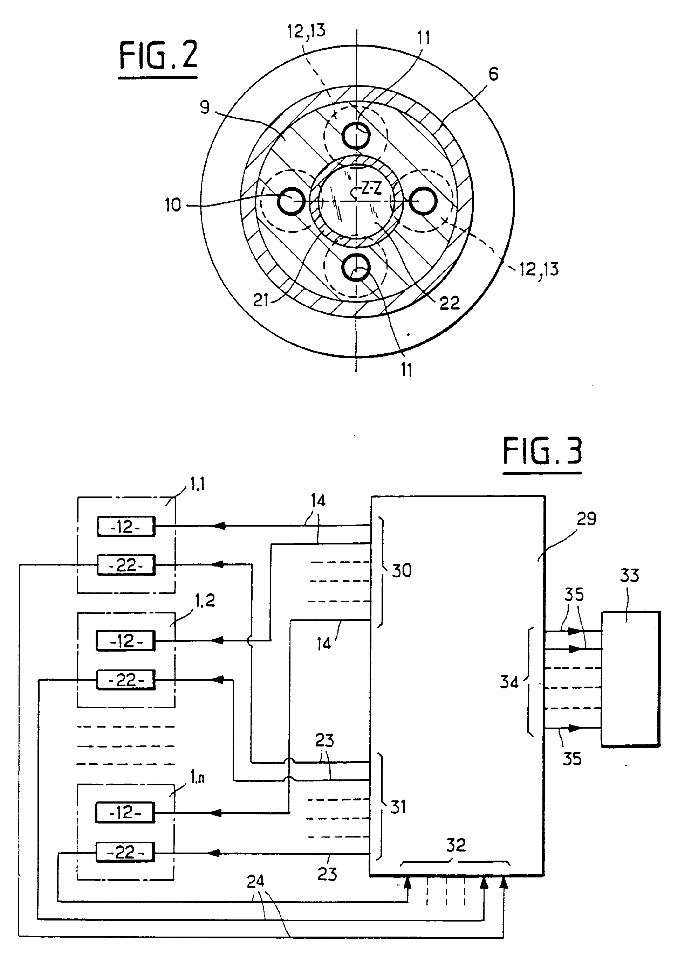

De plus, à l'intérieur du fourreau 6, est disposé et maintenu un corps cylindrique 9 axialement creux (voir également la figure 2). Le corps cylindrique 9 est percé de canaux cylindriques périphériques 10, parallèles à l'axe Z-Z. La paroi de chaque canal cylindrique 10 est revêtue d'une métallisation 11, réfléchissante. Les canaux cylindriques 10 sont par exemple au nombre de quatre et sont angulairement équirépartis autour de l'axe Z-Z.

A chaque canal cylindrique 10 est associée une diode électroluminescente 12, elle-même associée à une optique 13 de focalisation. Les diodes électroluminescentes 12 sont reliées à des conducteurs électriques 14. Elles sont portées par un support 15, lui-même supporté par le fourreau 6, et chacune d'elles se trouvent en regard d'un canal 10, à la base de celui-ci.

La cavité 2 du creuset 4a,4b est délimitée par un fond ou base 16, transparente et reposant sur la partie centrale du corps 9, et par une couronne périphérique 17, également transparente, comportant un chanfrein conique d' extrémité 18. La surface cylindrique extérieure de la base 16, porte une métallisation réfléchissante 19. De même, la surface extérieure de la couronne 17 et le chanfrein conique 18 porte une métallisation réfléchissante 20. Les métallisations 19 et 20 sont en prolongement des métallisations 11 des canaux 10.

A l'intérieur du corps 9 est disposé un manchon 21, qui maintient, du côté de sa base, une photodiode 22 reliée à des conducteurs 23 et 24. Dans le manchon 21, entre la base 16 de la cavité 2 et la photodiode 22, est agencé un système optique de focalisation, par exemple constitué de deux lentilles convergentes 25 et 26.

Ainsi, lorsque par l'intermédiaire des conducteurs 14, les diodes électroluminescentes 12 sont activées, elles émettent de la lumière qui, focalisée par les lentilles 13, pénètre dans les canaux 10. Par réflexion totale sur la paroi métallisée 11 desdits canaux, cette lumière se propage dans ceux-ci sous la forme de faisceaux, dont seuls les axes 27 ont été représentés sur la figure 1. Ces faisceaux continuent leur propagation grâce aux métallisations 19 et 20 des surfaces cylindriques extéreures de la base 16 et de la couronne périphérique 17. Cependant, à cause de la métallisation 20 du chanfrein conique 18, ces faisceaux sont déviés, par exemple à 90°, en direction de la cavité 2. Si cette cavité 2 contient des cristaux, ceux-ci sont éclairés par lesdits faisceaux déviés, de sorte qu'ils engendrent de la lumière diffusée (si ces cristaux sont petits) et/ou de la lumière diffractée (si ces cristaux sont gros).

Une partie de cette lumière diffusée et/ou diffractée traverse la base transparente 16 de la cavité 2 et le système optique forme un faisceau 28 (symbolisé sur la figure 1 par son axe confondu avec l'axe Z-Z), qui est reçu par la photodiode 22. Celle-ci, alimentée par son conducteur 23, délivre donc sur le conducteur 24 un signal électrique de sortie.

Ce signal de sortie de la photodiode 22, étant représentatif de l'intensité lumineuse du faisceau diffusé et/ou diffracté 28, qui lui-même est représentatif de l'état de la formation de cristaux à l'intérieur de la cavité 2, est donc représentatif de cet état.

Ainsi, grâce à l'invention, en suivant l'évolution du signal de sortie de la photodiode 22, on peut connaître à chaque instant l'état de la formation de cristaux à l'intérieur de la cavité 2.

Sur la figure 3, on a représenté schématiquement une pluralité de dispositifs 1, portant respectivement les références 1.1, 1.2,...,1.n et contrôlés par un dispositif de commande à micro-processeur 29. Celui-ci comporte un premier groupe de sorties 30 qui, par l'intermédiaire des conducteurs 14, sont capables de commander les diodes électroluminescentes de tous les dispositifs 1.1 à 1.n. Ce dispositif de commande 29 comporte de plus un second groupe de sorties 31 grâce auxquelles, par l'intermédiaire des conducteurs 23, il commande l'alimentation des photodiodes 22. Par ailleurs, le dispositif de commande 29 comporte un groupe d'entrées 32 qui, par l'intermédiaire des conducteurs 24, reçoivent les signaux de sortie desdites photodiodes 22.

Le dispositif 29 est capable de gérer les différents dispositifs 1.1 à 1.n et de transmettre à un dispositif d'affichage 33, par l'intermédiaire d'un groupe de sorties 34 et de liaisons 35, l'état instantané de la cristallisation dans la cavité 2 de chacun desdits dispositifs 1.1 à 1.n.

On remarquera que, même l'absence de cristallisation dans une cavité 2, le détecteur 22 correspondant reçoit de la lumière parasite. Il est donc indispensable de mesurer cette lumière parasite pour que le dispositif 29 en tienne compte et délivre des mesures relatives.

## Revendications

1. Dispositif de cristallogénèse comportant :
- un creuset (4a,4b) dans la cavité (2) duquel peut se produire une réaction de cristallisation ;
- des moyens de détection de lumière (22) disposés à l'extérieur de ladite cavité (2), du côté de la base (16) dudit creuset (4a,4b) ; et
- des premiers moyens de transmission de lumière (16,25,26) disposés entre la cavité (2) dudit creuset et lesdits moyens de détection de lumière (22) pour prélever dans ladite cavité (2) un premier faisceau lumineux (28) parallèle à une première direction,
caractérisé en ce qu'il comporte :
- des moyens générateurs de lumière (12) disposés à l'extérieur de ladite cavité (2), du côté de la base (16) dudit creuset (4a,4b) ; et
- des seconds moyens de transmission de lumière (10,11, 19,20) disposés entre lesdits moyens générateurs de lumière (12) et la cavité (2) dudit creuset (4a,4b) pour introduire dans ladite cavité (2) un second faisceau lumineux (27) parallèlement à une seconde direction, qui est transversale par rapport à ladite première direction.

2. Dispositif de cristallogénèse selon la revendication 1,
caractérisé en ce que ledit creuset (4a,4b), lesdits moyens générateurs de lumière (12), lesdits moyens de détection de lumière (22), lesdits premiers moyens de transmission de lumière (16,25,26) et lesdits seconds moyens de transmission de lumière (10,11,19,20) sont solidaires les uns des autres pour former une unité de cristallogénèse (1).

3. Dispositif de cristallogénèse selon la revendication 2,
caractérisé en ce que :
- ladite unité de cristallogénèse (1) comporte un axe géométrique (Z-Z) orthogonal à la base (16) dudit creuset (4a,4b) ;
- lesdits moyens générateurs de lumière (12) sont excentrés par rapport audit axe ;
- lesdits seconds moyens de transmission comportent au moins un conduit de lumière (10,11) excentré par rapport audit axe et des moyens de déflexion (20) pour défléchir ledit second faisceau lumineux (27) en direction de la cavité (2) dudit creuset (4a,4b) ;
- lesdits moyens de détection (22) de lumière sont centrés sur ledit axe ; et
- lesdits premiers moyens de transmission de lumière sont constitués au moins en partie par la base (16) dudit creuset (4a,4b), qui, à cet effet, est transparente pour ledit premier faisceau lumineux (28).

4. Dispositif de cristallogénèse selon la revendication 3,
caractérisé en ce que :
- lesdits moyens générateurs de lumière comportent une pluralité de sources lumineuses (12) réparties autour dudit axe ; et
- lesdits seconds moyens de transmission comportent une pluralité de conduits de lumière (10,11), dont chacun d'eux est associé à une source lumineuse.

5. Dispositif de cristallogénèse selon la revendication 4,
caractérisé en ce que lesdits moyens de déflexion sont constitués par un miroir conique (20), concentrique audit axe.

6. Dispositif de cristallogénèse selon la revendication 5,
caractérisé en ce que ledit miroir conique est formé par une face métallisée (20).

7. Dispositif de cristallogénèse selon l'une quelconque des revendications 3 à 6,
caractérisé en ce que le ou les conduits de lumière (10,11) sont constitués par des canaux cylindriques à paroi métallisée.

8. Dispositif de cristallogénèse selon l'une quelconque des revendications 3 à 7,
caractérisé en ce que le ou lesdits conduits de lumière (10,11) sont parallèles à l'axe de ladite unité de cristallogénèse.

9. Dispositif de cristallogénèse selon l'une quelconque des revendications 3 à 8,
caractérisé en ce que lesdits seconds moyens de transmission comportent un système optique de focalisation (13) entre lesdits moyens générateurs de lumière (12) et le ou lesdits conduits de lumière (10,11).

10. Dispositif de cristallogénèse selon l'une quelconque des revendications 3 à 9,
caractérisé en ce que lesdits premiers moyens de transmission (16,25,26) comportent un système optique de focalisation (25,26) entre la base (16) dudit creuset (4a,4b) et lesdits moyens de détection (22).

11. Dispositif de cristallogénèse selon l'une quelconque des revendications 1 à 10,
caractérisé en ce que lesdits moyens générateurs de lumière (12) et lesdits moyens de détection de lumière (22) sont électriques et en ce que des moyens de commande (29) sont prévus pour contrôler lesdits moyens générateurs de lumière (12) et lesdits moyens de détection de lumière (22) et pour délivrer un signal électrique représentatif de l'intensité lumineuse dudit premier faisceau lumineux (28).

12. Installation de cristallogénèse comportant une pluralité de dispositifs (1.1 à 1.n) dont chacun d'eux comprend :
- un creuset (4a,4b) dans la cavité (2) duquel peut se produire une réaction de cristallisation ;
- des moyens électriques de détection de lumière (22) disposés à l'extérieur de ladite cavité (2), du côté de la base dudit creuset (4a,4b) ; et
- des premiers moyens de transmission de lumière (16,25,26) disposés entre la cavité dudit creuset (4a,4b) et lesdits moyens de détection de lumière (22) pour prélever de ladite cavité (2) un premier faisceau lumineux (28) parallèle à une première direction,
caractérisée :
- en ce que chaque dispositif (1.1 à 1.n) comporte :
. des moyens électriques générateurs de lumière (12) disposés à l'extérieur de ladite cavité (2), du côté de la base (16) dudit creuset (4a,4b) ; et
. des seconds moyens de transmission de lumière (10,11, 19,20) disposés entre lesdits moyens générateurs de lumière (12) et la cavité (2) dudit creuset (4a,4b) pour introduire dans ladite cavité (2) un second faisceau lumineux (27) parallèlement à une seconde direction, qui est transversale par rapport à ladite première direction ;
- et en ce que sont prévus des moyens de commande (29) pour contrôler lesdits moyens générateurs de lumière (12) et lesdits moyens de détection de lumière (22) et pour délivrer des signaux électriques respectivement représentatifs de l'intensité lumineuse de chacun desdits premiers faisceaux lumineux (28).

## Patentansprüche

1. Vorrichtung zur Kristallzüchtung mit:
- einem Tiegel (4a,4b), in dessen Vertiefung (2) eine Kristallisationsreaktion erfolgen kann;
- lichterfassenden Mitteln (22), die außerhalb der Vertiefung (2) auf der Seite der Grundfläche (16) des Tiegels (4a,4b) angeordnet sind, und
- ersten Mitteln zur Lichtübertragung (16,25,26), die zwischen der Vertiefung (2) des Tiegels und den lichterfassenden Mitteln (22) angeordnet sind und aus der Vertiefung (2) ein erstes Lichtbündel (28) parallel zu einer ersten Richtung erhalten,
dadurch gekennzeichnet, daß sie umfaßt:
- lichterzeugende Mittel (12), die außerhalb der Vertiefung (2) auf der Seite der Grundfläche (16) des Tiegels (4a,4b) angeordnet sind, und
- zweite Mittel zur Lichtübertragung (10,11,19,20), die zwischen den lichterzeugenden Mitteln (12) und der Vertiefung (2) des Tiegels (4a,4b) angeordnet sind und in die Vertiefung (2) ein zweites Lichtbündel (27) parallel zu einer zweiten Richtung schicken, die quer zur ersten Richtung verläuft.

2. Vorrichtung zur Kristallzüchtung nach Anspruch 1,
dadurch gekennzeichnet, daß der Tiegel (4a,4b), die lichterzeugenden Mittel (12), die lichterfassenden Mittel (22), die ersten Mittel zur Lichtübertragung (16,25,26) und die zweiten Mittel zur Lichtübertragung (10,11,19,20) miteinander zu einer Rristallzüchtungseinheit (1) verbunden sind.

3. Vorrichtung zur Kristallzüchtung nach Anspruch 2,
dadurch gekennzeichnet, daß:
- die Rristallzüchtungseinheit (1) eine geometrische Achse (Z-Z) senkrecht zur Grundfläche (16) des Tiegels (4a,4b) hat;
- die lichterzeugenden Mittel (12) zu dieser Achse exzentrisch sind;
- die zweiten Mittel zur Lichtübertragung mindestens eine zu dieser Achse exzentrische Lichtleitung (10,11) und Ablenkmittel (20) haben, um das zweite Lichtbündel (27) in Richtung auf die Vertiefung (2) des Tiegels (4a,4b) abzulenken;
- die lichterfassenden Mittel (22) zentrisch zur Achse sind und
- die ersten Mittel zur Lichtübertragung zumindest teilweise aus der Grundfläche (16) des Tiegels (4a,4b) bestehen, die dazu für das erste Lichtbündel (28) transparent ist.

4. Vorrichtung zur Kristallzüchtung nach Anspruch 3,
dadurch gekennzeichnet, daß:
- die lichterzeugenden Mittel eine Vielzahl von Lichtquellen (12) haben, die um die Achse herum verteilt sind und
- die zweiten Mittel zur Lichtübertragung eine Vielzahl von Lichtleitungen (10,11) haben, die jeweils einer Lichtquelle zugeordnet sind.

5. Vorrichtung zur Kristallzüchtung nach Anspruch 4,
dadurch gekennzeichnet, daß die Ablenkmittel aus einem konischen Spiegel (20) bestehen, der zur Achse konzentrisch ist.

6. Vorrichtung zur Kristallzüchtung nach Anspruch 5,
dadurch gekennzeichnet, daß der konische Spiegel aus einer metallisierten Fläche (20) besteht.

7. Vorrichtung zur Kristallzüchtung nach einem der Ansprüche 3 bis 6,
dadurch gekennzeichnet, daß die Lichtleitung(en) (10,11) aus zylindrischen Kanälen mit metallisierter Wand bestehen.

8. Vorrichtung zur Kristallzüchtung nach einem der Ansprüche 3 bis 7,
dadurch gekennzeichnet, daß die Lichtleitungen (10,11) parallel zur Achse der Kristallzüchtungseinheit verlaufen.

9. Vorrichtung zur Kristallzüchtung nach einem der Ansprüche 3 bis 8,
dadurch gekennzeichnet, daß die zweiten Mittel zur Lichtübertragung ein optisches Fokussierungssystem (13) zwischen den lichterzeugenden Mitteln (12) und der oder den Lichtleitungen (10,11) haben.

10. Vorrichtung zur Rristallzüchtung nach einem der Ansprüche 3 bis 9,
dadurch gekennzeichnet, daß die ersten Mittel zur Lichtübertragung (16,25,26) ein optisches Fokussierungssystem (25,26) zwischen der Grundfläche (16) des Tiegels (4a,4b) und den lichterfassenden Mitteln (22) haben.

11. Vorrichtung zur Kristallzüchtung nach einem der Ansprüche 1 bis 10,
dadurch gekennzeichnet, daß die lichterzeugenden Mittel (12) und die lichterfassenden Mittel (22) elektrische Mittel sind, und dadurch, daß Steuermittel (29) vorgesehen sind, um die lichterzeugenden Mittel (12) und die lichterfassenden Mittel (22) zu kontrollieren und ein elektrisches Signal abzugeben, das für die Lichtstärke des ersten Lichtbündels (28) repräsentativ ist.

12. Anlage zur Kristallzüchtung mit einer Vielzahl von Vorrichtungen (1.1 bis 1.n), die jeweils umfassen:
- einen Tiegel (4a,4b), in dessen Vertiefung (2) eine Kristallisationsreaktion erfolgen kann;
- elektrische lichterfassende Mittel (22), die außerhalb der Vertiefung (2) auf der Seite der Grundfläche des Tiegels (4a,4b) angeordnet sind, und
- erste Mittel zur Lichtübertragung (16,25,26), die zwischen der Vertiefung des Tiegels (4a,4b) und den lichterfassenden Mitteln (22) angeordnet sind und aus der Vertiefung (2) ein erstes Lichtbündel (28) parallel zu einer ersten Richtung erhalten,
dadurch gekennzeichnet:
- daß jede Vorrichtung (1.1 bis 1.n) umfaßt:
. elektrische lichterzeugende Mittel (12), die außerhalb der Vertiefung (2) auf der Seite der Grundfläche (16) des Tiegels (4a,4b) angeordnet sind, und
. zweite Mittel zur Lichtübertragung (10,11,19.20), die zwischen den lichterzeugenden Mitteln (12) und der Vertiefung (2) des Tiegels (4a,4b) angeordnet sind und in die Vertiefung (2) ein zweites Lichtbündel (27) parallel zu einer zweiten Richtung schicken, die senkrecht zur ersten Richtung verläuft;
- und daß Steuermittel (29) vorgesehen sind, um die lichterzeugenden Mittel (12) und die lichterfassenden Mittel (22) zu kontrollieren und elektrische Signale abzugeben, die jeweils für die Lichtstärke jedes der ersten Lichtbündel (28) repräsentativ sind.

## Claims

1. Crystallogenesis device which includes:
- a crucible (4a,4b) in the cavity (2) of which a crystallization reaction may occur;
- light-detecting means (22) arranged outside the said cavity (2), on the side of the base (16) of the said crucible (4a,4b); and
- first light-transmitting means (16,25,26) arranged between the cavity (2) of the said crucible and the said light-detecting means (22) in order to take off, from the said cavity (2), a first light beam (28) parallel to a first direction,
characterized in that it includes:
- light-generating means (12) arranged outside the said cavity (2), on the side of the base (16) of the said crucible (4a,4b); and
- second light-transmitting means (10,11,19,20) arranged between the said light-generating means (12) and the cavity (2) of the said crucible (4a,4b) in order to introduce, into the said cavity (2), a second light beam (27) parallel to a second direction, which is transverse with respect to the said first direction.

2. Crystallogenesis device according to Claim 1, characterized in that the said crucible (4a,4b), the said light-generating means (12), the said light-detecting means (22), the said first light-transmitting means (16, 25,26) and the said second light-transmitting means (10,11,19,20) are solidly fastened to each other in order to form a crystallogenesis unit (1).

3. Crystallogenesis device according to Claim 2, characterized in that:
- the said crystallogenesis unit (1) has a geometrical axis (Z-Z) orthogonal to the base (16) of the said crucible (4a,4b);
- the said light-generating means (12) are off-centre with respect to the said axis;
- the said second transmitting means include at least one light guide (10,11) off-centre with respect to the said axis and deflection means (20) for deflecting the said second light beam (27) towards the cavity (2) of the said crucible (4a,4b);
- the said light-detecting means (22) are centered on the said axis; and
- the said first light-transmitting means are constituted, at least in part, by the base (16) of the said crucible (4a,4b), which base, for this purpose, is transparent for the said first light beam (28).

4. Crystallogenesis device according to Claim 3, characterized in that:
- the said light-generating means include a plurality of light sources (12) distributed around the said axis; and
- the said second transmitting means include a plurality of light guides (10,11), each of them being associated with a light source.

5. Crystallogenesis device according to Claim 4, characterized in that the said deflection means are constituted by a conical mirror (20), concentric with the said axis.

6. Crystallogenesis device according to Claim 5, characterized in that the said conical mirror is formed by a metallized face (20).

7. Crystallogenesis device according to any one of Claims 3 to 6, characterized in that the light guide or guides (10,11) are constituted by metallized-wall cylindrical channels.

8. Crystallogenesis device according to any one of Claims 3 to 7, characterized in that the said light guide or guides (10,11) are parallel to the axis of the said crystallogenesis unit.

9. Crystallogenesis device according to any one of Claims 3 to 8, characterized in that the said second transmitting means include an optical focusing system (13) between the said light-generating means (12) and the said light guide or guides (10,11).

10. Crystallogenesis device according to any one of Claims 3 to 9, characterized in that the said first transmitting means (16,25,26) include an optical focusing system (25,26) between the base (16) of the said crucible (4a,4b) and the said detecting means (22).

11. Crystallogenesis device according to any one of Claims 1 to 10, characterized in that the said light-generating means (12) and the said light-detecting means (22) are electrical and in that control means (29) are provided for controlling the said light-generating means (12) and the said light-detecting means (22) and for delivering an electrical signal representative of the light intensity of the said first light beam (28).

12. Crystallogenesis assembly which includes a plurality of devices (1.1 to 1.n), each of them comprising:
- a crucible (4a,4b) in the cavity (2) of which a crystallization reaction may occur;
- electrical light-detecting means (22) arranged outside the said cavity (2), on the side of the base of the said crucible (4a,4b); and
- first light-transmitting means (16,25,26) arranged between the cavity of the said crucible (4a,4b) and the said light-detecting means (22) in order to take off, from the said cavity (2), a first light beam (28) parallel to a first direction,
characterized:
- in that each device (1.1 to 1.n) includes:
. electrical light-generating means (12) arranged outside the said cavity (2), on the side of the base (16) of the said crucible (4a,4b); and
. second light-transmitting means (10,11,19,20) arranged between the said light-generating means (12) and the cavity (2) of the said crucible (4a,4b) in order to introduce, into the said cavity (2), a second light beam (27) parallel to a second direction, which is transverse with respect to the said first direction;
- and in that control means (29) are provided for controlling the said light-generating (12) means and the said light-detecting means (22) and for delivering electrical signals respectively representative of the light intensity of each of the said first light beams (28).
